# EUROPEAN PATENT APPLICATION

(11) **EP 2 048 711 A2**
(43) Date of publication of application: **15.04.2009**
(21) Application number: 08166387.4
(22) Date of filing: 10.10.2008
(51) Int. Cl.: H01L 23/12

(54) **Semiconductor package and manufacturing method thereof**

(30) Priority: 11.10.2007 JP 2007265789
(71) Applicant: Shinko Electric Industries Co., Ltd., Nagano-shi, Nagano 381-2287 (JP)
(72) Inventor: Taguchi, Yuichi, Nagano 381-2287 (JP); Shiraishi, Akinori, Nagano 381-2287 (JP); Sunohara, Masahiro, Nagano 381-2287 (JP); Murayama, Kei, Nagano 381-2287 (JP); Sakaguchi, Hideaki, Nagano 381-2287 (JP); Higashi, Mitsutoshi, Nagano 381-2287 (JP)
(74) Representative: Zimmermann & Partner

(57) **Abstract**

A semiconductor package 40 including a base body 10a having a recessed portion 16 for installing an electronic component on one surface, the recessed portion 16 including an inner bottom surface 16a, inclined surface and a shoulder part 16c and a wiring pattern 21 having one end positioned in the inner bottom surface 16a of the recessed portion 16 and the other end extending to an outside region of the recessed portion 16 beyond the shoulder part 16c of the recessed portion 16. The shoulder part 16c of the recessed portion 16 is a smoothly curved surface.

## Description

The present invention relates to a semiconductor package and a manufacturing method thereof, and more particularly to a semiconductor package having a recessed portion for installing an electronic component such as a semiconductor element or a light emitting element and a manufacturing method of the semiconductor package and a semiconductor apparatus using this semiconductor package.

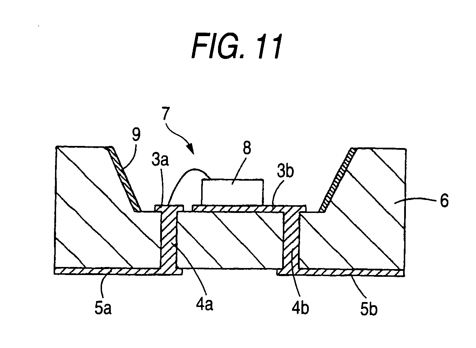

MEMS (Micro Electro Mechanical Systems) are formed by installing an electronic component such as a semiconductor element or a sensor on a silicon substrate. Fig. 11 is an example of a light emitting apparatus formed by installing a light emitting element 8 in a recessed portion 7 disposed in a base body 6 made of a silicon substrate. A pad 3a connected to the light emitting element 8 by wire bonding and a die pad 3b to which the light emitting element 8 is attached are disposed on an inner bottom surface of the recessed portion 7, and are respectively connected to wiring patterns 5a, 5b disposed on a lower surface of the base body 6 through conductive parts 4a, 4b penetrating through the base body 6 in a thickness direction. An inner side surface of the recessed portion 7 is covered with a metal film 9 for reflecting light emitted sideward from the light emitting element 8.

In the light emitting apparatus shown in Fig. 11, the light emitting element 8 is installed in the recessed portion 7 formed in the base body 6. As semiconductor apparatus in which a light emitting element or a semiconductor element is installed, there is a product in which a recessed portion for accommodating an electronic component is disposed in a base body and the electronic component is installed inside the recessed portion. In such a product, other than disposing the wiring patterns 5a, 5b on a surface opposite to the surface in which the recessed portion 7 of the base body 6 is disposed as shown in Fig. 11, it is considered to dispose a wiring pattern on the side of the same surface as a surface in which the recessed portion 7 of the base body 6 is disposed.

At least some of the problems in the art are overcome by the semiconductor package according to claim 1, the semiconductor apparatus according to claim 3, the mounting structure according to claim 5, and the method for manufacturing a semiconductor substrate according to claim 8. Further aspects, details and advantages are evident from the dependent claims, the description and the accompanying drawings. The invention provides a semiconductor package in which a recessed portion for installing an electronic component such as a semiconductor element or a light emitting element is disposed, and a preferred manufacturing method of this semiconductor package, and a novel semiconductor apparatus using this semiconductor package.

According to a first aspect of the invention, there is provided a semiconductor package including:
a base body having a recessed portion for installing an electronic component on one surface, the recessed portion including an inner bottom surface, inclined surface and a shoulder part and
a wiring pattern having one end positioned in the inner bottom surface of the recessed portion and the other end extending to an outside region of the recessed portion beyond the shoulder part of the recessed portion,
wherein the shoulder part of the recessed portion is a smoothly curved surface.
Here, the shoulder portion is a boundary defined between the inclined surface of the recessed portion and one surface of the base body.
It is adaptable that the base body is made of a silicon substrate.

According to a third aspect of the invention, there is provided a semiconductor apparatus including:
a semiconductor package including:
   a base body having a recessed portion on one surface, the recessed portion including an inner bottom surface, inclined surface and a shoulder part and
   a wiring pattern having one end positioned in the inner bottom surface of the recessed portion and the other end extending to an outside region of the recessed portion beyond the shoulder part of the recessed portion,
wherein the shoulder part of the recessed portion is a smoothly curved surface and
an electronic component electrically connected to the wiring pattern is installed in the recessed portion.
It is adaptable that the base body is made of a silicon substrate and the electronic component is a light emitting element.

According to a fifth aspect of the invention, there is provided a mounting structure of a semiconductor apparatus including:
a mounting substrate having a connection pad and
the semiconductor apparatus including:
   a semiconductor package including:
      a base body having a recessed portion on one surface, the recessed portion including an inner bottom surface, inclined surface and a shoulder part and
      a wiring pattern having one end positioned in the inner bottom surface of the recessed portion and the other end extending to an outside region of the recessed portion beyond the shoulder part of the recessed portion,
      wherein the shoulder part of the recessed portion is a smoothly curved surface and
   an electronic component electrically connected to the wiring pattern is installed in the recessed portion,
      wherein the semiconductor apparatus is bonded to the mounting substrate while facing the inner bottom surface of the recessed portion outward and
a part of the wiring pattern extending in the outside region of the recessed portion is electrically connected to the connection pad of the mounting substrate via a conductive part.

According to a sixth aspect of the invention, according to the fifth aspect of the invention, the conductive part is a wire.

According to a seventh aspect of the invention, according to the fifth aspect of the invention, the conductive part penetrates through the base body in an outside region of the recessed portion.

According to an eighth aspect of the invention, there is provided a manufacturing method of a semiconductor package, including:
forming a mask pattern, which exposes portions of a surface of a substrate corresponding to positions of recessed portions to be formed in a semiconductor package, on the surface of the substrate for a base body of the semiconductor package;
etching the substrate in a thickness direction by using the mask pattern as a mask and forming the recessed portion in which an inner bottom surface is a flat surface and an inner side surface is an inclined surface;
removing the mask pattern from the substrate;
polishing the surface of the substrate in which the recessed portion is formed so as to chamfer a shoulder part of the recessed portion in a smoothly curved surface;
forming a wiring pattern having one end positioned in the inner bottom surface of the recessed portion and the other end extending to an outside region of the recessed portion beyond the shoulder part of the recessed portion,
separating the substrate into individual segments so as to make individual semiconductor packages.
In this manufacturing method, it is adaptable that
a silicon wafer is used as the substrate, and
the silicon wafer is thermally oxidized so that a surface of the silicon wafer is covered with an oxide film,
the oxide film is etched so as to expose the portions of the surface of the silicon wafer corresponding to the arrangement of the recessed portion formed in the semiconductor package to thereby form the mask pattern made of the oxide film and
the recessed portion is formed by etching the silicon wafer by using the mask pattern made of the oxide film as a mask.
Further, in this manufacturing method, it is adaptable that the method further including:
forming a resist film and patterning the resist film and / or
forming the wiring pattern by using the patterned resist film as a mask.

According to a semiconductor package and a manufacturing method of the semiconductor package according to the invention, a shoulder part of a recessed portion which installs an electronic component and is, preferably, formed in a base body of the semiconductor package is formed in a smoothly curved surface, so that a wiring pattern can be formed with high accuracy in the case of forming the wiring pattern beyond the shoulder part of the recessed portion from an inner bottom surface of the recessed portion.
Embodiments are also directed to apparatuses for carrying out the disclosed methods and including apparatus parts for performing each described method steps. These method steps may be performed by way of hardware components, a computer programmed by appropriate software, by any combination of the two, or in any other manner. Furthermore, embodiments are also directed to methods by which the described apparatus operates or by which the described apparatus is manufactured. It includes method steps for carrying out functions of the apparatus or manufacturing parts of the apparatus.

Embodiments of the present disclosure will be described with respect to the accompanying drawings in more detail in the following.
Figs. 1A to 1C are sectional view and a plan view showing a configuration of an embodiment of a semiconductor package and a semiconductor apparatus;
Figs. 2A to 2C are a sectional view and a plan view showing a configuration of another embodiment of a semiconductor package and a semiconductor apparatus;
Figs. 3A to 3E are sectional views showing manufacturing processes to formation of a recessed portion in a silicon wafer;
Figs. 4A to 4D are sectional views showing manufacturing processes to formation of the recessed portion in the silicon wafer;
Fig. 5 is a plan view of a state of forming a resist pattern on a surface of a silicon wafer;
Fig. 6 is a plan view of a state of performing wet etching of a silicon wafer;
Figs. 7A and 7B are sectional views showing a shape of a recessed portion before and after polishing;
Figs. 8A to 8F are sectional views showing another manufacturing process of forming a wiring pattern;
Figs. 9A to 9F are sectional views showing a manufacturing process of forming a wiring pattern;
Figs. 10A to 10C are a sectional views showing a mounting structure of a semiconductor apparatus and
Fig. 11 is a sectional view showing a configuration of a conventional semiconductor package.

### (Configuration of semiconductor package)

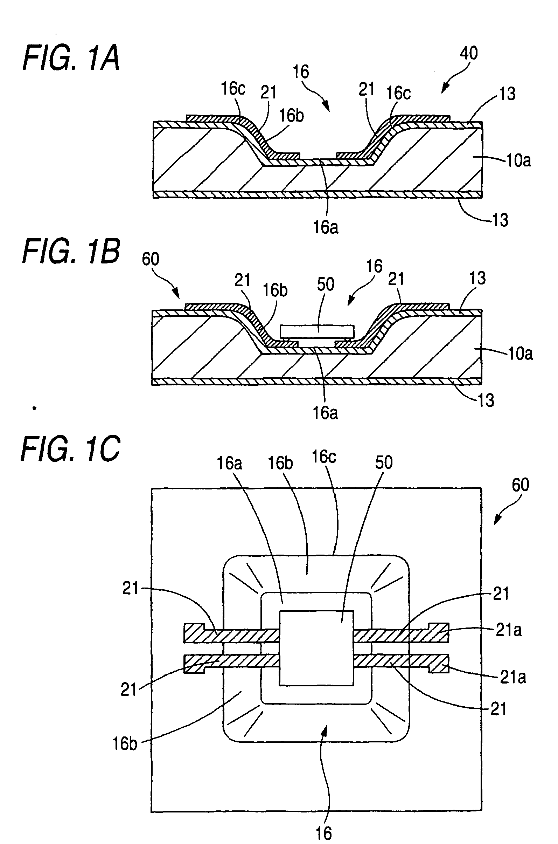

Fig. 1 shows a first embodiment of a semiconductor package according to the invention. In a semiconductor package 40 of the present embodiment, a recessed portion 16 for installing an electronic component is formed on a surface of a base body 10a made of silicon and wiring patterns 21 are formed on the same surface side of the base body 10a on which the recessed portion 16 is formed.

In the recessed portion 16, an inner bottom surface 16a on which the electronic component is installed is formed as a flat surface and an inner side surface 16b is formed as an inclined surface in which an opening side of the recessed portion 16 gradually becomes wider. A shape of the recessed portion 16 is characterized in that a cross-sectional shape of a shoulder part (opening edge) 16c of the recessed portion 16 is formed in a smoothly curved surface. One end of the wiring pattern 21 is positioned in the inner bottom surface 16a of the recessed portion 16 and the other end is formed so as to extend to the outside of the opening edge beyond the shoulder part 16c of the recessed portion 16.
An upper surface and a lower surface including an inner surface of the recessed portion 16 of the base body 10a are covered with an oxide film (silicon oxide film) 13 formed by thermally oxidizing a silicon base body material.

Fig. 1B shows a semiconductor apparatus 60 in which a light emitting element 50 as an electronic component is installed on the semiconductor package 40. Fig. 1C is a plan view of the semiconductor apparatus 60.
As shown in Fig. 1B, the light emitting element 50 is surface-mounted on the wiring patterns 21 formed on the inner bottom surface 16a of the recessed portion 16. Light sidewardly emitted from the light emitting element 50 is reflected by the inner side surface 16b formed on the inclined surface of the recessed portion 16 and is emitted in a direction vertical to a plane of the package. In order to improve reflection characteristics of the light emitted from the light emitting element 50, it is also effective to apply resin etc. to the inner side surface 16b.

As described above, the wiring pattern 21 is drawn from the inner bottom surface 16a of the recessed portion 16 to the outside of the recessed portion 16 beyond the shoulder part 16c. Fig. 1C shows an example in which the end 21a of the wiring pattern 21 is formed widely and is formed as a connection pad.
The wiring patterns 21 has a configuration that two lines extend from the light emitting element 50 in right side and left side, respectively. That is, four lines extend from the light emitting element 50. The number of lines and a design of the wiring patterns 21 formed in the semiconductor package can be designed arbitrarily according to the electronic component to be installed.

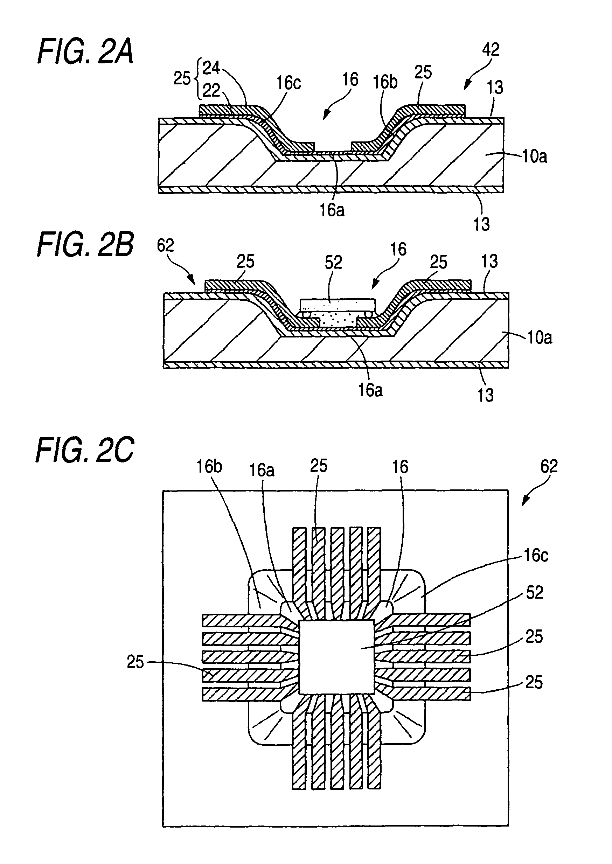

Fig. 2A shows another embodiment of a semiconductor package. In the semiconductor package 40 shown in Fig. 1, a conductive layer is formed by a sputtering method and the wiring patterns 21 are formed by a subtractive method. A semiconductor package 42 shown in Fig. 2 is formed by a plating method using a semi-additive method. A wiring pattern 25 is constructed of a plated seed layer 22 and a plated layer 24 formed by electrolytic plating.
In this embodiment, the configurations, in which a recessed portion 16 for installing an electronic component is provided on a surface of a base body 10a made of silicon and a wiring pattern 25 extends from an inner bottom surface 16a of the recessed portion 16 beyond an inner side surface 16b and a shoulder part 16c, are similar to that of the semiconductor package 40 shown in Fig. 1.

Figs. 2B and 2C show a configuration of a semiconductor apparatus 62 in which a semiconductor element 52 is installed in the semiconductor package 42. The semiconductor element 52 is connected to the wiring patterns 25 formed on the inner bottom surface 16a of the recessed portion 16 by flip chip connection.
As shown in Fig. 2C, plane shape of the wiring patterns 25 is that lines are drawn from the square shaped recessed portion 16.
Note that, when mounting the semiconductor element 52 onto the semiconductor package 42, instead of the flip chip connection, the wire bonding connection can be applied.

### (Manufacturing method of semiconductor package)

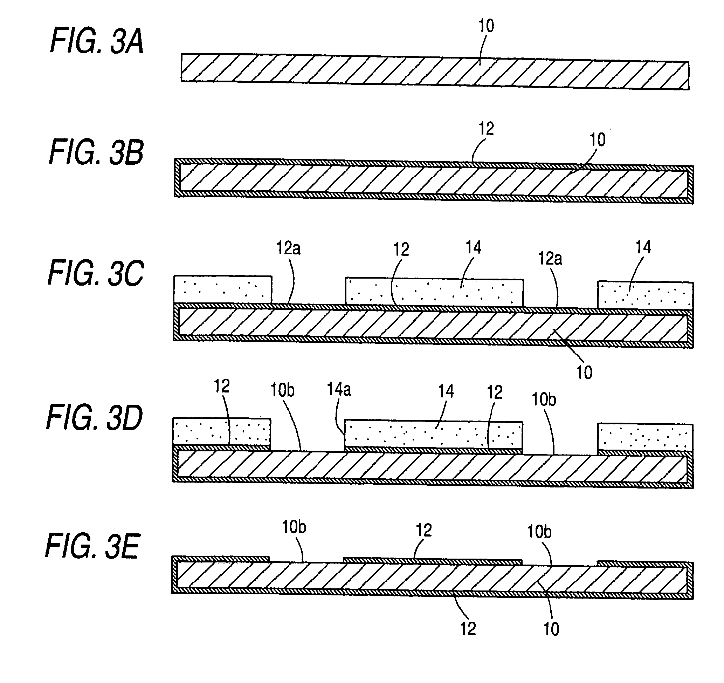

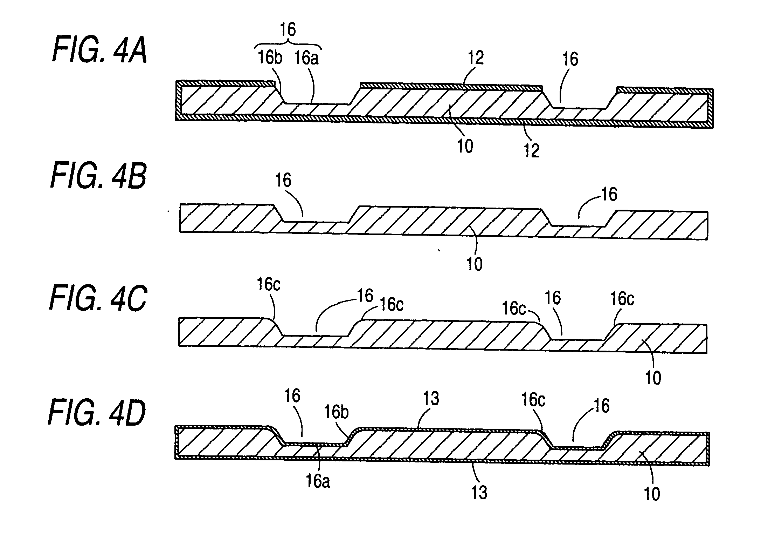

Figs. 3 and 4 show a process of forming the recessed portion 16 in the base body 10a made of silicon in a manufacturing process of the semiconductor package 40 shown in Fig. 1.
Fig. 3A shows a silicon wafer 10 constructing a base body portion of the semiconductor package.
Fig. 3B shows a state of forming an oxide film (SiO₂) 12 on a surface of the silicon wafer 10. The silicon wafer 10 is placed in a heating furnace and oxidative gas is introduced into the heating furnace and the silicon wafer 10 is heated at about 1000 °C. By doing so, the surface of the silicon wafer 10 is thermally oxidized and the oxide film 12 is formed on the surface of the silicon wafer 10.

Fig. 3C shows a state in which a resist pattern 14 is formed on one surface of the silicon wafer 10 on which the oxide film 12 is formed. The resist pattern 14 is formed in a predetermined pattern by exposure and development after applying spin coating of resist on the surface of the silicon wafer 10 . The resist pattern 14 can also be formed by a printing method.

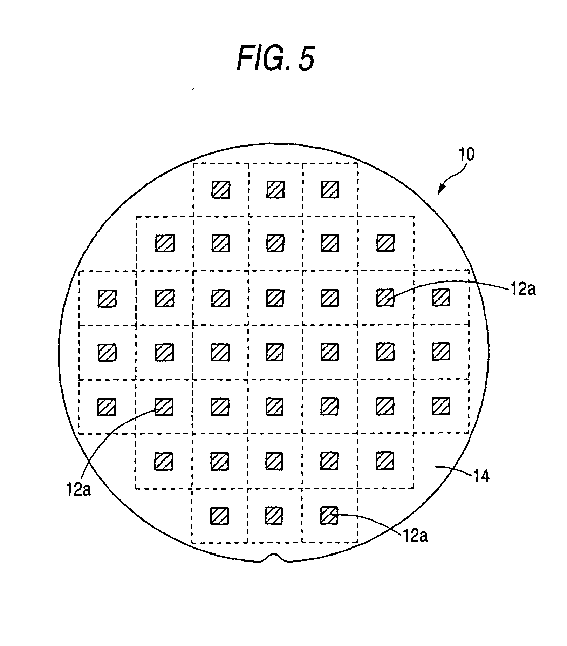

Fig. 5 shows a state of the resist patter 14 formed on the surface of the silicon wafer 10 from a direction perpendicular to a plane of the silicon wafer 10. The resist pattern 14 is formed on the surface of the silicon wafer 10 so that exposed parts 12a of the oxide film 12 are aligned in a matrix. The positions of the exposed parts 12a correspond to positions in which the recessed portions of the semiconductor package are to be formed, respectively.

The exposed part 12a of the oxide film 12 is a square shape in a plane shape, but a size and a shape of the exposed part 12a could be set according to a shape of the recessed portion formed in the semiconductor package. Since multiple semiconductor packages are formed from one silicon wafer 10, when patterning the resist, the arrangement of the exposed parts 12a is set in accordance with a plane arrangement of the the semiconductor packages to be formed on the silicon wafer 10.

After the resist pattern 14 is formed, the exposed parts 12a of the oxide film 12 are removed by using the resist pattern 14 as a mask (Fig. 3D). The oxide film 12 can be removed by etching using, for example, a hydrofluoric acid/ammonium fluoride aqueous solution. By removing the exposed parts 12a of the oxide film 12, exposed parts 10b, on which a base body material of the silicon wafer 10 is exposed, is formed on opening parts 14a of the resist pattern 14.

Next, the resist pattern 14 is removed (Fig. 3E). The resist pattern 14 can be removed so as to leave the oxide film 12 by chemical etching. Consequently, an external surface of the silicon wafer 10 is covered with an oxide film (silicon oxide) 12 and exposed parts 10b of the silicon wafer 10 are arranged in a predetermined arrangement on one surface of the silicon wafer.

Then, wet etching of the silicon wafer 10 is performed. This wet etching aims to form the recessed portion 16 in the silicon wafer 10 by etching the silicon wafer 10 from only the exposed parts 10b of the silicon wafer 10. As an etching solution of the silicon wafer 10, for example, a potassium hydroxide aqueous solution is used. By this etching, the oxide film 12 is not etched and the silicon wafer 10 is etched from only the exposed parts 10b of the silicon wafer 10.

Fig. 4A shows a state where wet etching is carried out on the silicon wafer 10. The silicon wafer 10 is etched from the exposed parts 10b in a depth direction and the recessed portions 16 are formed in the respective exposed parts 10b.

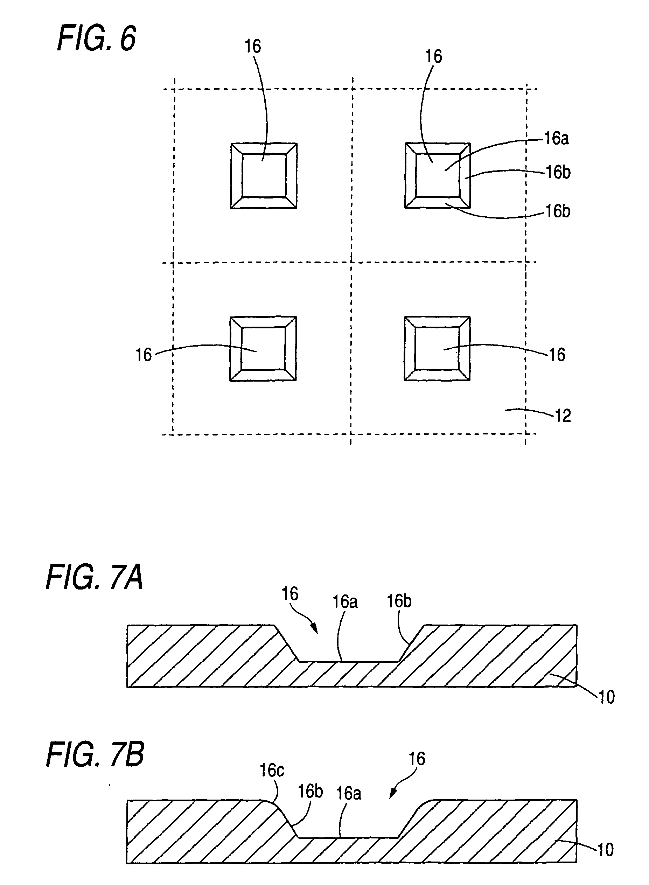

Fig. 6 shows a state where the recessed portion 16 is formed on the silicone wafer 10 from a direction perpendicular to the plane of the silicon wafer 10. The inner bottom surface 16a of the recessed portion 16 is formed in a flat shape and the inner side surface 16b is formed in an inclined surface. When carrying out the wet etching of the silicon wafer 10, an etching condition such as an etching solution is selected so as to form the inclined surface in which the upper side of the inner side surface 16b of the recessed portion 16 becomes wide. Since a crystal plane direction of the silicon wafer 10 is a plane (100), the inner side surface 16b of the recessed portion 16 is formed in the inclined surface when a normal etching solution is used.
A depth of the recessed portion 16 can be controlled by selecting wet etching time or an etching solution. The depth of the recessed portion 16 depends on a thickness of an electronic component installed in the semiconductor package, and is about 100 µm to 500 µm.

In addition, as a method for forming the recessed portion 16 in the silicon wafer 10, a method for etching by combining anisotropic etching and isotropic etching can also be used instead of the wet etching.

After performing the wet etching on the silicon wafer 10, the oxide film 12 is removed by using a hydrofluoric acid etc. in a manner similar to the process of Fig. 3D (Fig. 4B). In this process, all the oxide film 12 adhering to the surface of the silicon wafer 10 is removed.
Fig. 4C shows a state where polishing is carried out on one surface on which the recessed portions 16 of the silicon wafer 10 are formed. When carrying out the wet etching on the silicon wafer 10 to form the recessed portion 16, an opening edge of the recessed portion 16 becomes sharp edge. Therefore, the polishing process is performed so as to round a shoulder part (edge part) 16c of the opening edge so that the shoulder part 16 becomes smoothly curved surface.

Fig. 7 enlarges a cross-sectional shape of the recessed portion 16 before and after the silicon wafer 10 is polished.
Fig. 7A shows a cross-sectional shape of the recessed portion 16 in Fig. 4B and Fig. 7B shows a cross-sectional shape of the recessed portion 16 in Fig. 4C.
As shown in Fig. 7A, the opening edge of the recessed portion 16 is formed in an angular edge shape just after the wet etching of the silicon wafer 10 is performed and the recessed portion 16 is formed. On contrary, by polishing the silicon wafer 10, the shoulder part 16c of the opening edge of the recessed portion 16 is formed in a shape chamfered in a smoothly curved surface shape. Here, for an example, it is preferable that the curvature radius of the curved surface is about 5µm.

An object of the polishing of the silicon wafer 10 is to form the shoulder part 16c of the recessed portion 16 in a smoothly curved surface shape. When contacting the silicon wafer 10 with a polishing cloth of a polishing apparatus to polish, the polishing cloth enters the recessed portion 16 and the shoulder part 16c of the recessed portion 16 is polished so as to be chamfered and the shoulder part 16c is formed in a smooth shape. As a polishing method, proper polishing such as chemical polishing (CMP) can be used.

Fig. 4D shows a state where an oxide film 13 is formed on the surface of the silicon wafer 10 after the silicon wafer 10 is polished. This oxide film 13 is also formed by thermally oxidizing the silicon wafer 10. All the surfaces of the silicon wafer 10 including the inner bottom surface 16a, the inner side surface 16b and the shoulder part 16c of the recessed portion 16 are covered with the oxide film 13 by the thermal oxidation.
The oxide film (silicon oxide) 13 is formed on the surface of the silicon wafer 10 for the purposes of ensuring durability and temporal stability of a silicon substrate used as a base body of a semiconductor package and being utilized as an insulating layer which prevents short-circuit of the wiring pattern formed on the surface of the silicon base body.

### (Formation process of wiring pattern)

A method for forming a wiring pattern on the silicon wafer 10 in which the recessed portion 16 is formed will hereinafter be described.

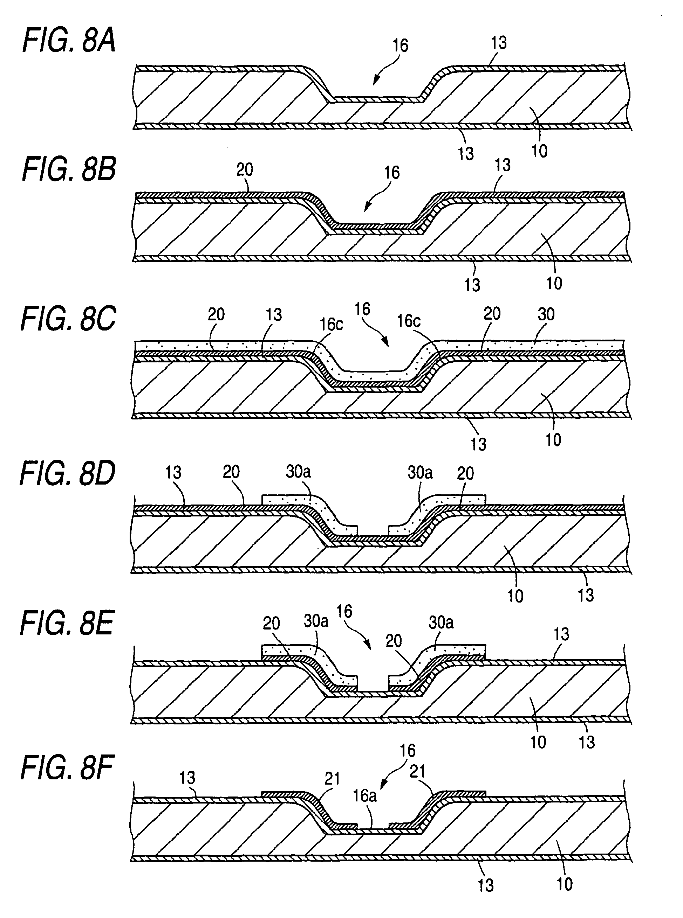

Fig. 8 shows a process example of forming a wiring pattern by a subtractive method.
Fig. 8A is a state shown in Fig. 4D, that is, a state where the surface of the silicon wafer 10 is covered with the oxide film 13. Hereinafter, for the purpose of explanation, a state of forming a wiring pattern in one recessed portion 16 of the silicon wafer 10 is shown.

Fig. 8B shows a state where a conductive layer 20 constructing a wiring pattern is formed. The conductive layer 20 is formed by forming a film at the total thickness of about 1 µm and layered Ti/Pt/Au layers in this order by, for example, a sputtering method. The Ti layer is a layer for improving adhesiveness between the conductive layer 20 and the backing oxide film 13, and the Au layer is disposed as a protective layer of a surface of the wiring pattern. Of course, a layer configuration of the conductive layer 20 can be selected optionally. Further, the conductive layer 20 can be formed by a plating method such as electroless copper plating rather than the sputtering method. When employing the sputtering method, the conductive layer 20 can be made thin and it is effective when forming the wiring pattern in a fine pattern.

Fig. 8C shows a state where one surface covered with the conductive layer 20 of the silicon wafer 10 is covered with a resist 30. The resist 30 is applied by spin coating. In this embodiment, because the shoulder part 16c of the recessed portion 16 formed in the silicon wafer 10 is formed in a smoothly curved surface, when performing the spin coating the resist 30 on the surface of the silicon wafer 10, the resist 30 is surely retained on the shoulder part 16c of the recessed portion 16.
When the shoulder part 16c of the recessed portion 16 is formed in an edge shape, when performing the spin coating of the resist 30, liquid of the resist 30 runs out in the shoulder part 16c of the recessed portion 16 and, for example, when a thickness of the resist 30 is thin, the resist 30 does not adhere and the resist 30 may be cut. On the other hand, when chamfering the shoulder part 16c of the recessed portion 16 in a smoothly curved surface shape as described in the embodiment, it is effective in the respect that the resist 30 can surely be retained to the shoulder part 16c.

Fig. 8D shows a state of forming resist patterns 30a by exposing and developing the resist 30. The resist patterns 30a are formed so as to cover the portion of the conductive layer 20 which should be left for forming the wiring patterns.
It is necessary to form the resist patterns 30a with high accuracy in order to form the wiring pattern in a high-definition pattern. Since the resist pattern 30a is formed by exposing and developing the resist 30, it is desirable to form the resist 30 thinner in order to form the resist pattern 30a in the high-definition pattern. In the embodiment, liquid of the resist is prevented from running out in the shoulder part 16c of the recessed portion 16 and thereby, a thickness of the resist 30 can be thinned and the resist pattern 30a can be formed with higher accuracy and the wiring patterns can be formed with high accuracy and at high density.

After the resist pattern 30a is formed, the conductive layer 20 exposed to the surface of the silicon wafer 10 is removed by a dry etching method using the resist patterns 30a as a mask. By the dry etching, the conductive layer 20 is removed excluding the portion of the conductive layer 20 covered with the resist patterns 30a and the oxide film 13 is exposed to the surface of the silicon wafer 10 in which the conductive layer 20 is removed (Fig. 8E) . As the dry etching method of the conductive layer 20, for example, an RIE (Reactive Ion gas Etching) method can be used.

Fig. 8F shows a state where the resist patterns 30a deposited on the surface of the silicon wafer 10 is removed and wiring patterns 21 are formed in the recessed portion 16 formed in the silicon wafer 10. An electronic component such as a semiconductor element or a light emitting element is installed on an inner bottom surface 16a of the recessed portion 16. Therefore, in the wiring pattern 21, one end of the pattern is positioned in the inner bottom surface 16a of the recessed portion 16 and the other end is drawn outwardly from the opening edge of the recessed portion 16. Since the surface of the silicon wafer 10 is covered with the oxide film 13, the wiring patterns 21 are not short-circuited electrically.
After the wiring patterns 21 are formed on the surface of the silicon wafer 10 in a predetermined pattern, the silicon wafer 10 is diced in individual segments and thereby, the semiconductor package 40 shown in Fig. 1A can be obtained.

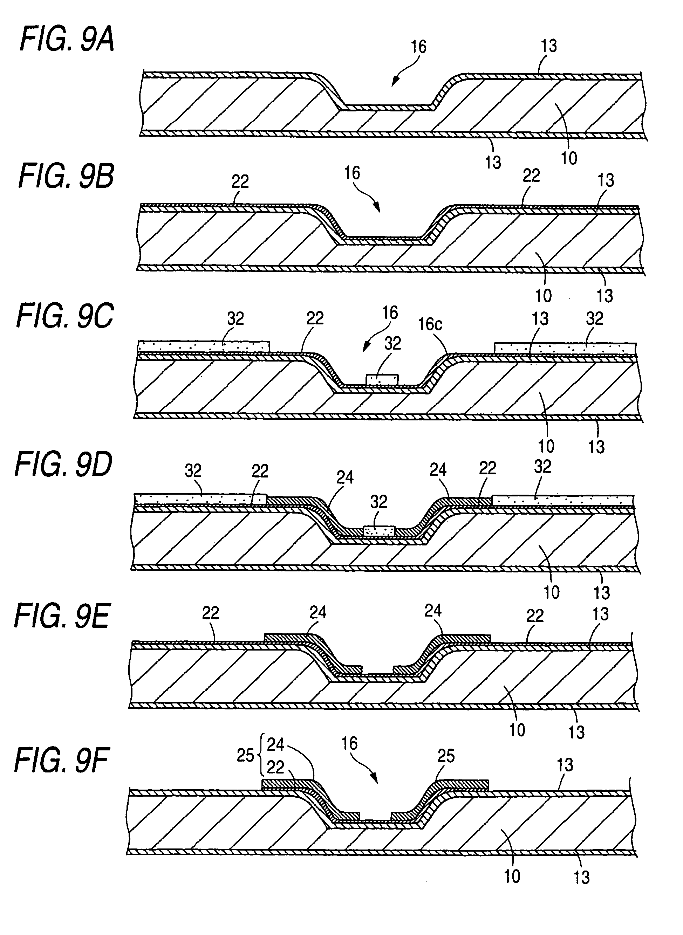

Fig. 9 shows an example of forming a wiring pattern by a plating method (semi-additive method).
Fig. 9A is a silicon wafer 10 in which a recessed portion 16 is formed and a surface is covered with an oxide film 13.
First, by a sputtering method, a plated seed layer 22 made of Ti/Cu layers is formed on a surface in which the recessed portion 16 of the silicon wafer 10 is formed. The Ti layer is disposed in order to improve adhesiveness between the silicon wafer 10 and a conductive layer. The Cu layer is used as a plated power feeding layer for electrolytic plating.

Next, spin coating of a resist is performed on a surface of the silicon wafer 10 and the resist is exposed and developed thus resist patterns 32 are formed (Fig. 9C). in this embodiment, a shoulder part 16c of the recessed portion 16 is also chamfered in a smoothly curved surface, and thereby, liquid of the resist is prevented from running out by the shoulder part 16c of the recessed portion 16 when performing the spin coating of the resist and the whole surface of the silicon wafer 10 can be covered with the resist and the resist patterns 32 can be formed with high accuracy. In the semi-additive method, the resist patterns 32 are formed so as to expose the portion in which wiring patterns are formed on the plated seed layer 22.

Fig. 9D shows a state in which electrolytic copper plating using the plated seed layer 22 as a plated power feeding layer is performed and plating is bulged in an exposed part of the plated seed layer 22 and a plated layer 24 is formed. The plated layer 24 results in a conductor part of the wiring pattern and the plated layer 24 is formed by bulging the plating to a thickness of about 8 to 10 µm.

Then, the resist patterns 32 are removed (Fig. 9E) and the portion of the plated seed layer 22 covered with the resist patterns 32 is removed by etching and wiring patterns 25 are formed on the silicon wafer 10 (Fig. 9F) . In the wiring pattern 25, the plated layer 24 is laminated on the plated seed layer 22.
Since a thickness of the plated layer 24 is much thicker than that of the plated seed layer 22, the exposed portion of the plated seed layer 22 can be removed selectively by using an etching solution for removing the plated seed layer 22 without covering the plated layer 24 with a resist etc. when etching the exposed portion of the plated seed layer 22.
Then, the semiconductor package 42 shown in Fig. 2A can be obtained by dicing the silicon wafer 10 in individual segments.

As described above, in the manufacturing method of the semiconductor package of the embodiment, the silicon wafer is a targeted work, performing the wet etching collectively on the silicon wafer 10, polishing the wafer 10, forming the resist patterns and finally dicing the silicon wafer 10 in individual segments thus, the semiconductor package is obtained. Therefore, the method can be effective used as a mass production method of the semiconductor package.

### (Mounting structure of semiconductor apparatus)

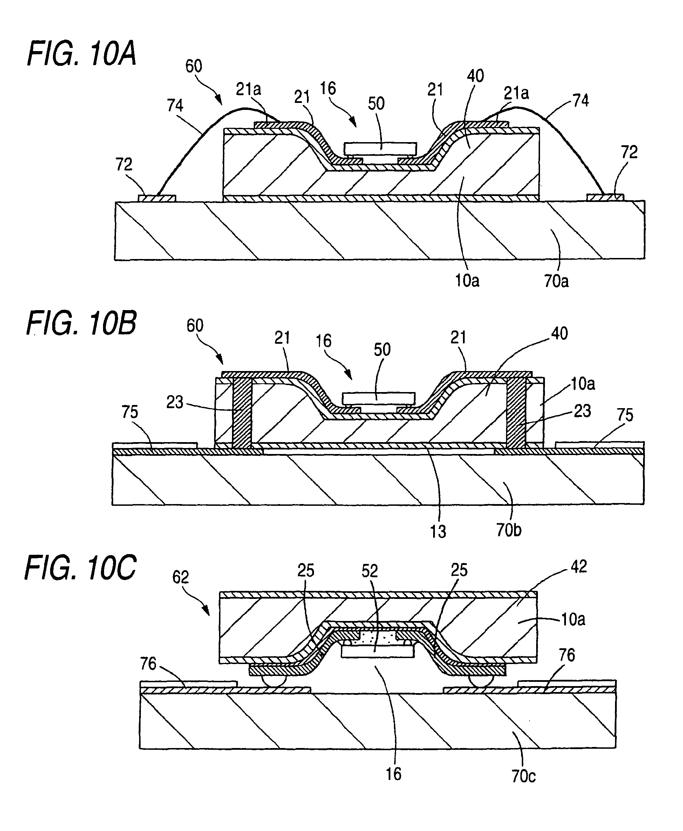

Fig. 10 shows an example of a mounting structure of installing an electronic component in the semiconductor package 40, 42 formed by the method described above and mounting the semiconductor package on a mounting substrate.
Fig. 10A is an example of mounting a semiconductor apparatus 60 in which a light emitting element 50 is installed in the semiconductor package 40 on a mounting substrate 70a. The semiconductor apparatus 60 is bonded to the mounting substrate 70a while setting the light emitting element 50 upward. That is, the light emitting element 50 faces opposite side of the mounting substrate 70a. Further, connection pads 72 formed on the mounting substrate 70a are connected to the ends 21a of wiring patterns 21 of the semiconductor apparatus 60 by bonding wires 74.

The ends 21a of the wiring patterns 21 are positioned in flat parts of a base body 10a of an outside region of a recessed portion 16. Further, the ends 21a of the wiring patterns 21 and the connection pads 72 are positioned in the same surface side with respect to a bonding tool in a state of bonding the semiconductor apparatus 60 to the mounting substrate 70a. Therefore, the semiconductor apparatus 60 can easily be connected to the mounting substrate 70a by wire bonding.

In addition, when a semiconductor element is installed in the semiconductor package 40 by wire bonding connection in the mounting structure of the configuration shown in Fig. 10A, a bonding wire is connected to the wiring pattern 21 in the vicinity of the semiconductor element and the wiring pattern 21 extends to the end of the base body 10a, so that connection from the end of the wiring pattern 21 to another mounting structure etc. can be made further by wire bonding.
Since the wire bonding connection technique is a highly completed technique, reliability as a semiconductor apparatus improves. Further, wire bonding at a long distance is not required, more improvement in reliability and cost reduction can be achieved.

Fig. 10B is an example constructed so that conductive parts 23 penetrating through a base body 10a in a thickness direction are disposed in the semiconductor package 40 and the semiconductor package 40 is mounted on a mounting substrate 70b. The conductive parts 23 are disposed so as to be electrically connected to wiring patterns 21 in flat parts of an outside region of the recessed portion 16. The conductive part 23 can be formed by boring a through hole in the silicon wafer 10 and filling the through hole by plating in a process of manufacturing the semiconductor package 40.
When disposing the conductive parts 23 in the base body 10a, the semiconductor apparatus 60 is mounted by connecting to wiring patterns 75 formed on the mounting substrate 70b on a back surface (surface opposite to a surface in which the recessed portion 16 is formed) of the base body 10a. The conductive parts 23 may be connected to the wiring patterns 75 of the mounting substrate 70b through a connection terminal such as a solder bump. In this case, connection to the mounting substrate 70b can be made inside a plane region of the semiconductor package 40 and space savings in connection space can be achieved.

Fig. 10C is an example of mounting a semiconductor apparatus 62 in which a semiconductor element 52 is installed in the semiconductor package 42 on a mounting substrate 70c. In the semiconductor package 42, the opening side of a recessed portion 16 is opposed to the mounting substrate 70c and wiring patterns 25 extending in an outside region of the recessed portion 16 are bonded to wiring patterns 76 formed on the mounting substrate 70c by solder and are mounted. This bonding configuration is similar to the configuration of mounting a general semiconductor apparatus on a mounting substrate.

In the embodiments described above, the semiconductor apparatus 60, 62 in which the light emitting element 50 or the semiconductor element 52 is installed in the base body 10a made of silicon has been described, but an electronic component installed in the recessed portion 16 formed in the base body 10a can be selected properly, and the arrangement and the number of the electronic component installed in the recessed portion 16 can be designed properly. The semiconductor package of the invention can be constructed as the semiconductor apparatus including a complex function by properly installing various electronic components thus, and these semiconductor apparatuses can be mounted on the mounting substrate by the mounting structure shown in Fig. 10.

In addition, in the embodiments described above, the semiconductor package has been formed using the silicon wafer 10 as a base body material, but an insulator such as glass other than silicon can also be used as the base body material of the semiconductor package. For example, when glass is used as the base body material of the semiconductor package, a glass plate resulting in a base body of the semiconductor package is etched and a recessed portion for installing an electronic component is formed and thereafter the glass plate is polished and a shoulder part of the recessed portion is chamfered smoothly and thereby, a semiconductor package in which a wiring pattern is extended from an inner bottom surface of the recessed portion to an outside region of an opening part of the recessed portion can be formed by a method similar to the method described above.

Also, in the embodiments described above, the shoulder part 16c of the recessed portion 16 has been formed in a smoothly curved surface so as to prevent liquid of a resist from running out when performing spin coating of the resist when a resist pattern is formed in a process of forming a wiring pattern, but this method is not intended for only a solution of a problem of performing spin coating of the resist. For example, when attaching a resist to a surface of a substrate by an electrodeposition method, similar action and effect can be obtained. When employing the electrodeposition method, a power feeding layer is disposed on the surface of the substrate such as a silicon wafer and the resist is electrodeposited, and a problem that the resist becomes resistant to adhering to an edge part of a recessed portion arises when the resist is thinly electrodeposited in order to form a fine pattern at a high density. Also in this case, forming the shoulder part 16c of the recessed portion 16 in a smoothly curved surface is effective.

While the invention has been described in connection with the exemplary embodiments, it will be obvious to those skilled in the art that various changes and modifications may be made therein without departing from the present invention, and it is aimed, therefore, to cover in the appended claim all such changes and modifications as fall within the true spirit and scope of the present invention.

## Claims

1. A semiconductor package (40) comprising:
a base body (10a) having a recessed portion (16) for installing an electronic component on one surface, the recessed portion (16) comprising an inner bottom surface (16a), inclined surface and a shoulder part (16c) and
a wiring pattern (21) having one end positioned in the inner bottom surface (16a) of the recessed portion (16) and the other end extending to an outside region of the recessed portion (16) beyond the shoulder part (16c) of the recessed portion (16),
wherein the shoulder part (16c) of the recessed portion (16) is a smoothly curved surface.

2. The semiconductor package as set forth in claim 1,
wherein the base body (10a) is made of a silicon substrate.

3. A semiconductor apparatus (60) comprising:
a semiconductor package comprising:
a base body (10a) having a recessed portion (16) on one surface, the recessed portion (16) comprising an inner bottom surface (16a), inclined surface and a shoulder part and
a wiring pattern (21) having one end positioned in the inner bottom surface (16a) of the recessed portion (16) and the other end extending to an outside region of the recessed portion (16) beyond the shoulder part of the recessed portion (16),
wherein the shoulder part of the recessed portion (16) is a smoothly curved surface and
an electronic component electrically connected to the wiring pattern (21) is installed in the recessed portion (16).

4. The semiconductor apparatus as set forth in claim 3, wherein the base body (10a) is made of a silicon substrate and/or
the electronic component is a light emitting element.

5. A mounting structure of a semiconductor apparatus (60) comprising:
a mounting substrate (70a) having a connection pad (72) and
the semiconductor apparatus (60) comprising:
a semiconductor package (40) comprising:
a base body (10a) having a recessed portion (16) on one surface, the recessed portion (16) comprising an inner bottom surface, inclined surface and a shoulder part and
a wiring pattern (21) having one end positioned in the inner bottom surface of the recessed portion (16) and the other end extending to an outside region of the recessed portion (16) beyond the shoulder part of the recessed portion (16),
wherein the shoulder part of the recessed portion (16) is a smoothly curved surface and
an electronic component electrically connected to the wiring pattern (21) is installed in the recessed portion (16),
wherein the semiconductor apparatus (60) is bonded to the mounting substrate (70a) while facing the inner bottom surface of the recessed portion (16) outward and
a part of the wiring pattern (21) extending in the outside region of the recessed portion (16) is electrically connected to the connection pad (72) of the mounting substrate (70a) via a conductive part.

6. The mounting structure of the semiconductor apparatus as set forth in claim 5, wherein the conductive part is a wire.

7. The mounting structure of the semiconductor apparatus as set forth in claims 5 or 6, wherein the conductive part penetrates through the base body (10a) in an outside region of the recessed portion (16).

8. A manufacturing method of a semiconductor package, comprising:
forming a mask pattern, which exposes portions of a surface of a substrate corresponding to positions of recessed portions to be formed in a semiconductor package, on the surface of the substrate for a base body of the semiconductor package;
etching the substrate in a thickness direction by using the mask pattern as a mask and forming the recessed portion in which an inner bottom surface is a flat surface and an inner side surface is an inclined surface;
removing the mask pattern from the substrate;
polishing the surface of the substrate in which the recessed portion is formed so as to chamfer a shoulder part of the recessed portion in a smoothly curved surface;
forming a wiring pattern having one end positioned in the inner bottom surface of the recessed portion and the other end extending to an outside region of the recessed portion beyond the shoulder part of the recessed portion,
separating the substrate into individual segments so as to make individual semiconductor packages.

9. The manufacturing method of the semiconductor package as set forth in claim 8, wherein
a silicon wafer is used as the substrate, and /or
the silicon wafer is thermally oxidized so that a surface of the silicon wafer is covered with an oxide film,
the oxide film is etched so as to expose the portions of the surface of the silicon wafer corresponding to the arrangement of the recessed portion formed in the semiconductor package to thereby form the mask pattern made of the oxide film and / or
the recessed portion is formed by etching the silicon wafer by using the mask pattern made of the oxide film as a mask.

10. The manufacturing method of the semiconductor package as set forth in claims 8 or 9, further comprising:
forming a resist film and patterning the resist film and / or
forming the wiring pattern by using the patterned resist film as a mask.
